# EUROPEAN PATENT SPECIFICATION

(11) **EP 2 313 937 B1**
(45) Date of publication and mention of the grant of the patent: **19.03.2014**
(21) Application number: 09788846.5
(22) Date of filing: 29.06.2009
(51) Int. Cl.: H01L 35/30, H01L 35/32

(54) **STACKED THERMOELECTRIC MODULES**
GESTAPELTE THERMOELEKTRISCHE MODULE
MODULES THERMOÉLECTRIQUES EMPILÉS

(30) Priority: 14.07.2008 US 172396
(43) Date of publication of application: 27.04.2011
(73) Proprietor: Alcatel Lucent, 75007 Paris (FR)
(72) Inventor: HODES, Marc, S., Dublin 4 (IE)
(74) Representative: Wetzel, Emmanuelle
(86) International application number: PCT/US2009/003855
(87) International publication number: WO 2010/008495

(56) References cited:
- WO-A1-98/56047
- FR-A1- 2 419 479
- US-A- 3 356 539
- US-A- 4 125 122
- US-A- 5 254 178
- US-A1- 2002 062 648
- US-A1- 2004 076 214

## Description

### TECHNICAL FIELD OF THE INTENTION

The invention is directed, in general, to thermoelectric modules.

### BACKGROUND OF THE INVENTION

Thermoelectric modules (TEMs) are a class of semiconductor-based devices that may be used to, e.g., heat or cool an object, or may be used to generate power when placed between a heat source and a heat sink. Generally, semiconductor pellets of alternating doping type are arranged in series electrically and in parallel thermally. As current flows through the pellets, one side of the TEM becomes colder, and the other warmer. Conversely, when placed in a thermal gradient, the TEM may drive a current through a load. A TEM may be used to cool or heat a device, or to maintain an operating temperature with the aid of a feedback control loop.

US 4,125,122 describes a method and apparatus for directly converting heat to electricity within an array of thermoelements and heat pipes. The thermoelectric generator contains two conduits for two fluid streams, and a plurality of thermal bridges connecting points in both fluid streams, placing them in an overall counterflow heat exchange relationship. Each thermal bridge comprises at least one heat exchange surface with the first fluid stream, at least one heat exchange surface with the second fluid stream and at least one heat pipe, delivering heat to and/or from the thermoelectric element. The rapid heat delivery capability of the heat pipes, in combination with the counterflow heat exchange relationship between the two fluid streams within the generator, are responsible for the simultaneous considerable improvement of efficiency and power density of the generator.

WO 98/56047 describes a thermo-electric battery that comprises two semi-conductive branches of the p- and n-type connected by switching buses as well as conductors and metallic thermal junctions. The thermo-electric cooling unit of the present invention comprises a set of thermo-electric batteries as well as channels on the side of the hot and cool thermal junctions for circulating a liquid heat carrier, wherein said channels define cold and hot circulation loops for the heat carrier. WO 98/56047 also relates to a device for heating and cooling a liquid, wherein said device comprises thermo-electric batteries as well as heat-exchangers for the hot and cold loops of the liquid flow. The heat-exchangers are made in the shape of alternating channels of the cold and hot loops of the liquid flow, wherein the upper and lower walls of said channels are formed respectively by the hot and cold thermal junctions of the batteries. The batteries are mounted in parallel relative to each other and separated by a gap, wherein liquid-tight surfaces are placed between the batteries.

### SUMMARY OF THE INVENTION

An apparatus and a method according to the independent claims are provided.

One embodiment is an apparatus including a first thermally conductive body having at least one finger and a second thermally conductive body having a plurality of fingers that are configured such that at least a first finger and a second finger of the plurality of fingers include a portion of a same vapor chamber. The second body provides a path for vapor transport from the first finger to the second finger. The plurality of fingers are further configured such that at least one finger of the first thermally conductive body is interdigitated with the first finger and the second finger of the second thermally conductive body. The apparatus comprises a plurality of thermoelectric modules located between the first thermally conductive body and the second thermally conductive body. Each thermoelectric module of the plurality of thermoelectric modules has at least one semiconducting pellet located entirely between a first major surface and an opposing second major surface thereof. The first major surfate is in thermal contact with the at least one finger of the first thermally conductive body, and the second major surface is in thermal contact with the first finger or the second finger of the second thermally conductive body.

Another embodiment is a method that includes providing a first thermally conductive body having at least one finger and a second thermally conductive body having a plurality of fingers. The plurality of fingers are configured such that at least a first finger and a second finger of the plurality of fingers include a portion of a same vapor chamber, and the second body provides a path for vapor transport from the first finger to the second finger. The first and second thermally conductive bodies are configured such that the at least one finger of the first thermally conductive body is interdigitated with the first finger and the second finger of the second thermally conductive body. The method further comprises locating a plurality of thermoelectric modules between the first thermally conductive body and the second thermally conductive body. Each thermoelectric module of the plurality of thermoelectric modules has at least one semiconducting pellet located entirely between a first major surface and an opposing second major surface thereof. The first major surface is configured to be in thermal contact with the at least one finger of the first thermally conductive body, and the second major surface is configured to be in thermal contact with the first finger or the second finger of the second thermally conductive body.

Another embodiment is a system that includes the disclosed apparatus and a controller that is configured to control a rate of heat transport between the first thermally conductive body and the second thermally conductive body through the plurality of thermoelectric modules.

### BRIEF DESCRIPTION OAF THE DRAWINGS

Various embodiments are understood from the following detailed description, when read with the accompanying figures. Various features may not be drawn to scale and may be arbitrarily increased or reduced in size for clarity of discussion. Various features in figures may be described as "vertical" or "horizontal" for convenience in referring to those features. Such descriptions do not limit the orientation of such features with respect to the natural horizon or gravity. Reference is now made to the following descriptions taken in conjunction with the accompanying drawings, in which:
FIG. 1A illustrates an example embodiment of an apparatus comprising thermoelectric modules stacked vertically;
FIG. 1B illustrates an example embodiment of an apparatus comprising thermoelectric modules stacked horizontally;
FIGs. 2A-2C illustrate positioning of two thermally conductive bodies having a number of fingers;
FIG. 3 illustrates an example of circulation of a working fluid and vapor in two thermally conductive bodies, each containing a vapor chamber and thermally coupled to TEMs;
FIG. 4 illustrates an exploded view of a TEM in thermal contact with each of two fingers;
FIG. 5 illustrates TEMs and four fingers configured to produce power in response to heat produced by a heat source;
FIGs. 6A-6C illustrate an example embodiment in which a heat pipe and a thermally conductive block form fingers of a thermally conductive body; and
FIG. 7 illustrates an example method.

### DETAILED DESCRIPTION

A thermoelectric module (TEM) typically is assembled from a number of n-doped and p-doped pellets connected electrically in series and thermally in parallel. When an externally applied potential causes electrons and/or holes to flow through the pellets, a temperature difference is maintained across the pellets. The pellets are electrically connected to each other in series in alternating fashion such that one side of the TEM becomes cooler in response to current flow, and the other side becomes warmer. Thus the TEM may be used as a heat pump. Operation of the TEM is reversible in the sense that when a thermal gradient is imposed across the pellets of a TEM, a potential is produced that may be harnessed to produce work.

As current flows through the pellets, Joule heating (I²R) causes power to dissipate in the pellets. The dissipated power raises the temperature of the pellets, reducing pumping efficiency. The dissipated power also increases the heat to be removed by the TEM. Thus, in general, the efficiency of a TEM is greater for a lower pumping current than for a higher pumping current. However, the lower the pumping current, the lower the rate of heat transfer. This tradeoff typically leads to a design compromise particular to the requirements of a specific system design.

Efficiency of a TEM may be increased by increasing the area of the TEM so the current through each pellet is reduced, and/or thermally isolating, e.g., insulating, the hot and cold sides of the pellets to a greater degree. U.S. Patent Application Serial No. 12/128,478 to Hodes, et al. discloses an apparatus in which heat from a heat source is spread laterally using a thermally conductive substrate such as, e.g., a vapor chamber. The laterally conductive substrate allows the use of a larger TEM, which may reduce the heat flux per unit area (unit heat flux) through the TEM, thus allowing the TEM to operate with greater efficiency. However, this approach may require the use of greater area of a circuit assembly substrate (e.g., a printed circuit board) in a cooling or temperature control application, or in a waste heat recovery application, such as, e.g., from an automobile exhaust system. In such cases it may be prohibitively expensive and/or impractical to provide greater area to the TEM to achieve greater efficiency of operation. What is needed is an alternative method to reduce the current density through TEM pellets that consumes less area on a circuit assembly substrate.

The described embodiments benefit from the recognition that TEMs may be stacked, but operated thermally in parallel to decrease the unit heat flux through the TEMs while reducing the required circuit assembly substrate area. Thus, the effective area used to spread heat from, e.g., a heat-producing device, is increased by extending the TEMs vertically with respect to the substrate rather than horizontally. The vertical assembly utilizes a thermally conductive body to configure the TEMs in parallel thermally, as described further below.

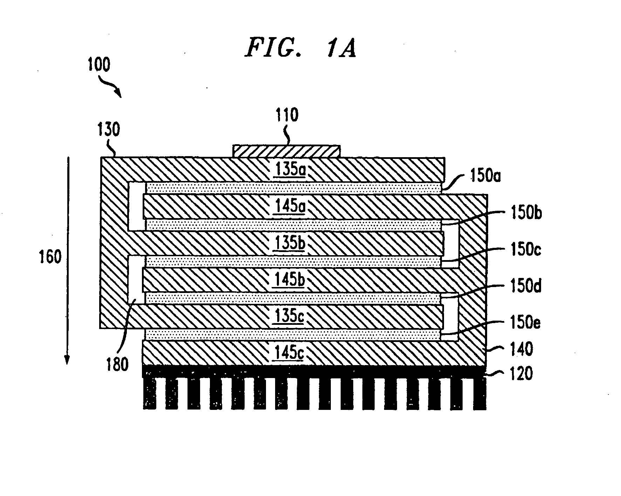

Turning initially to FIG. 1A, illustrated is a sectional view of an example apparatus 100. The apparatus 100 includes a heat source 110 and a heat sink 120. The heat source 110 is in thermal contact with a first thermally conductive body 130. The heat sink 120 is in thermal contact with a second thermally conductive body 140. As used herein, thermal contact between a first and a second element means that heat from the first element flows substantially through the area over which the first element is in physical with the second element.

The heat source 110 may be any source of heat. In some embodiments, the heat source 110 is an electronic device configured to produce heat when energized, such as, e.g., a microprocessor, power amplifier, or high power laser. In other embodiments, the heat source may be a source of waste heat such as, e.g., a smoke stack or a catalytic converter of an automobile. The apparatus 100 may be configured to cool the heat source 110, to maintain a temperature thereof, or to recover power from the waste heat. If a temperature is maintained, a controller including, e.g., an active feedback loop, may be used. In still other embodiments, the heat source 110 may be a passive device, such as a sensor, e.g., that does not dissipate heat, but is maintained by the apparatus 100 at a desired operating temperature.

The thermally conductive body 130 includes fingers, e.g., fingers 135a, 135b, 135c (collectively referred to as fingers 135). The thermally conductive body 140 also includes fingers, e.g., fingers 145a, 145b, 145c (collectively fingers 145). While the thermally conductive bodies 130, 140 are each shown having three fingers, embodiments are contemplated having fewer or more fingers. The thermally conductive bodies 130, 140 may have the same number of fingers, as illustrated, but embodiments having unequal numbers of fingers are within the scope of this disclosure. The fingers 135, 145 are interdigitated, as described in greater detail below. A TEM 150a is located between the fingers 135a, 145a. Similarly, TEMs 150b, 150c, 150d, 150e are located between the remaining fingers 135, 145. as illustrated. (TEMs 150a, 150b, 150c, 150d, 150e are referred to collectively as TEMs 150.) Thus, the heat sinks 150 are stacked vertically with respect to the heat sink 120. A space 180 is not occupied by either a TEM or a thermally conductive body.

The combination of thermally conductive paths provided by the thermally conductive bodies, and thermal insulation provided by the TEMs results in a compact, space filling assembly. The thermally conductive paths may be chosen to conduct heat in a predetermined three-dimensional thermal circuit to provide a larger TEM surface area to pump heat, or recover waste heat, than would otherwise be possible in the footprint of the assembly. This configuration in effect provides, for the case of cooling the heat source 110, a single evaporator at the portion of the thermally conductive body 130 in thermal contact with the heat source 110, and multiple condensers at the portions of the thermally conductive body 140 that are in thermal contact with the TEMs 150. For the case that heat is transferred to the heat source 110, the situation is reversed-in effect the portions of the thermally conductive body 140 in thermal contact with the heat sink 120 act as a single evaporator, and the portions of the thermally conductive body 130 in thermal contact with the TEMs 150 act as multiple condensers.

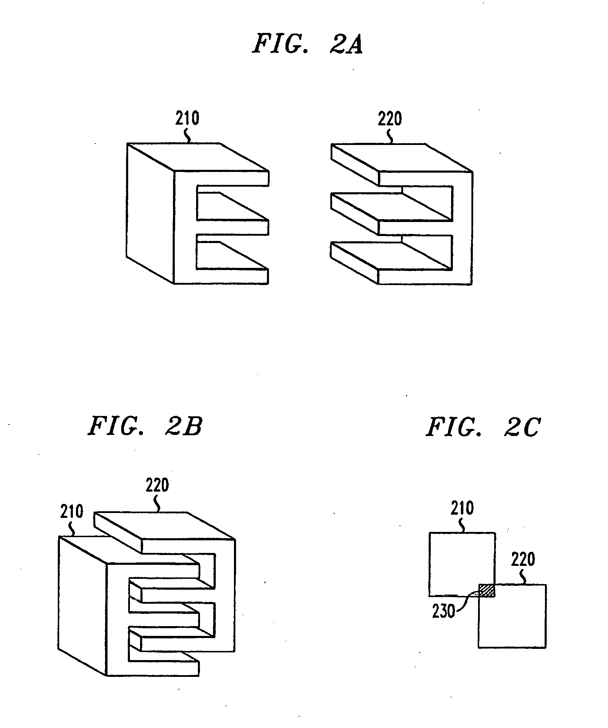

Turning briefly to FIGs. 2A and 2B, illustrated is a perspective view of two configurations of a thermally conductive body 210 and a thermally conductive body 220 relative to each other. Each thermally conductive body 210, 220 includes three fingers for illustration purposes only. In FIG. 2A, the fingers do not overlap to any extent. In this case, the set of fingers of the thermally conductive body 210 are disjoint from the set of fingers of the thermally conductive body 220. In FIG. 2B, the bodies 210, 220 are configured such that the fingers at least partially overlap. In this case, the fingers are described as interdigitated. Typically, as illustrated in FIG. 2B, the bodies will be configured to maximize the overlap and therefore the available area for heat flow from one thermally conductive body to the other thermally conductive body. FIG. 2C illustrates in plan view an embodiment in which the overlap is relatively small. Though the overlap is small, the fingers of the body 210 and the fingers of the body 220 are regarded as interdigitated. As the term is used herein, any nonzero overlap is within the scope of the meaning of "interdigitated." Note that the extent of overlap has two degrees of freedom.

Returning to FIG. 1A, the flow of heat through the TEMs 150 results in a net heat flow 160 from the heat source 110 to the heat sink 120. Because at least some heat from the heat source 110 flows through each of the TEMs 150a-150e, the effective area over which heat from the heat source 110 flows is greater than the area of any one of the TEMs 150a-150e, and the efficiency of the TEMs is increased. In some embodiments the TEMs 150 are each configured to transport heat from the thermally conductive body 130 to the thermally conductive body 140. In other embodiments, the TEMs 150 are each configured to transport heat from the thermally conductive body 140 to the thermally conductive body 130. For example, it may desirable to heat the heat source 110 to maintain a set temperature. In other embodiments, described further below, the TEMs 150 are configured to produce power in response to the heat from the heat source 110.

The thermally conductive bodies 130, 140 may be formed from any material generally accepted as thermally conductive, typically about 200 W/m-K or greater. The body may include a layer designed to increase thermal conductivity in one or more directions relative to the surface of the thermally conductive bodies 130, 140. Examples materials include, e.g., metals such as aluminum, copper, silver, and gold; composites such as A1/SiC; ceramics such as beryllium oxide (beryllia); and carbon-based thermal conductors such as diamond films and pyrolitic graphite. In some cases, the thermal conductivity is about 400 W/m-K or greater. In some embodiments, described further below, the thermally conductive bodies 130, 140 may include a vapor chamber or heat pipe, in which case the effective thermal conductivity may be about 5000 W/m-K or greater in at least some directions. The thermally conductive bodies 130, 140 may formed of the same or different materials, may have a same or different thermal conductivity characteristic, and may have fingers 135, 145 of a same or different geometry.

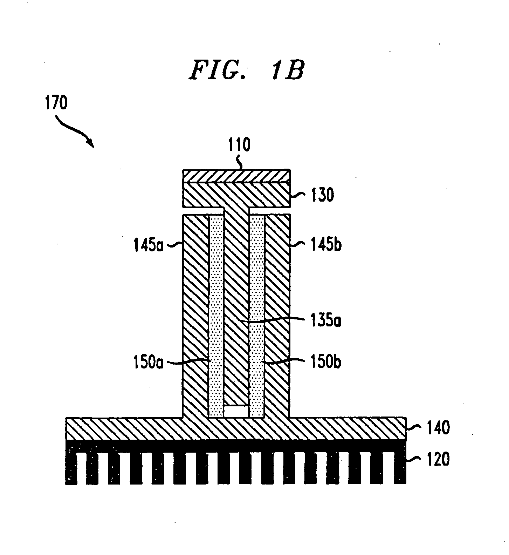

FIG. 1B illustrates an example apparatus 170 comprising TEMs 150a, 150b stacked horizontally with respect to the heat sink 120. In the illustrated case, the thermally conductive body 130 has only one finger, and the thermally conductive body 140 has two fingers. The stack may be extended horizontally by increasing the number of fingers on the thermally conductive body 130 and/or the thermally conductive body 140. In some cases, the thermally conductive body 130 and the TEMs 150a, 150b are planar. In other cases, the fingers 145a, 145b are portions of a single, annular structure surrounding the finger 135a. In such cases, the TEMs 150a, 150b may be physically disjoint or may be portions of an annular TEM surrounding the finger 135a. Details of annular TEMs are disclosed in U.S. Patent Application Serial. No. 11/618,056 by Hodes. The stack may be extended vertically by increasing the size of the TEMs 150a, 150b.

In the apparatus 100 and the apparatus 170, any TEM may optionally be replaced with a thermally insulating material if desired. For example, it may be desired to design a specific heat flux value through one or several TEMs 150. Moreover, insulation may optionally be placed in a void space, e.g., the space 180, to increase thermal isolation of the thermally conductive bodies 130, 140. Examples of insulating materials include expanded polystyrene and aerogel.

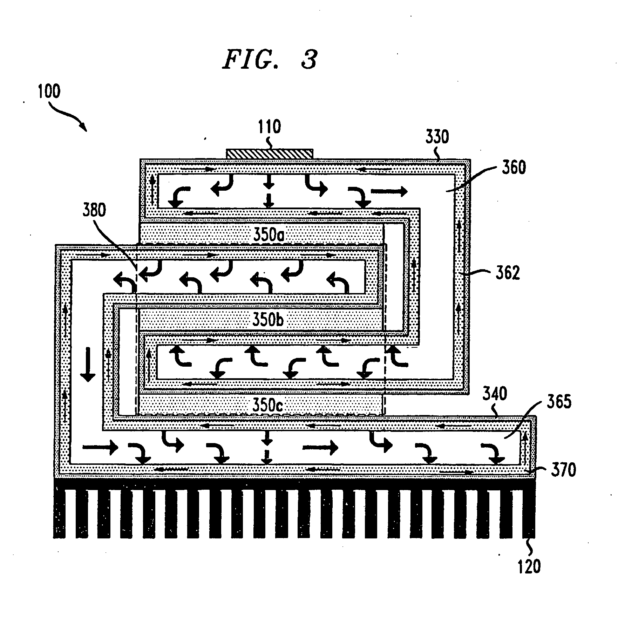

Turning to FIG. 3, illustrated is an example apparatus 300 including two thermally conductive bodies 330, 340. The thermally conductive bodies 330, 340 each have, e.g., two fingers, and contain a vapor chamber 360, 365, respectively. The fingers of the thermally conductive bodies 330, 340 are interdigitated. The heat source 110 is in thermal contact with the thermally conductive body 320, and the heat sink 120 is in thermal contact with the thermally conductive body 340. TEMs 350a, 350b, 350c (collectively TEMs 350) are located between the fingers of the thermally conductive body 330 and the thermally conductive body 340. The TEMs 350 are configured in this illustrated embodiment to pump heat from the thermally conductive body 330 to the thermally conductive body 340. Thus the surface of each TEM 350 in contact with the thermally conductive body 330 is colder than the surface in contact with the thermally conductive body 340. A portion 380 is demarcated for later discussion.

The operation of a vapor chamber is described, e.g., in the '478 application, and is summarized here using the thermally conductive body 330 as an example for the case the TEMs 350 are configured to pump heat from the thermally conductive body 330 to the thermally conductive body 340. The vapor chamber 360 includes a wick 362 lining one or more interior surfaces of a chamber that is otherwise hollow, with the exception of any needed structural supports. The wick 362 is wetted with a working fluid such as alcohol or water. When an exterior surface of the chamber is in contact with a heat source, the working fluid in the vicinity of the contact area evaporates into the vapor chamber 360 and is transported away from the heated area. The phase change carries the heat of evaporation away from the heated area. The vapor may then condense on the wick in a cooler region of the chamber. The phase change releases the heat of condensation in the cooler region. In this manner, the effective lateral thermal conductivity (e.g., parallel to the lined interior surface) may be 10X-100X the thermal conductivity of a solid metal thermal conductor. Thermal conductivity ranging from 5,000-20,000 W/m-K is possible.

Heat from the heat source 110 flows to the thermally conductive body 330. The working fluid in the wick 362 proximate the heat source 110 vaporizes and enters the vapor chamber 360 open volume of the vapor chamber 360. The vapor diffuses through the vapor chamber 360 to the portions thereof proximate the TEMs 350a, 350b, 350c. Because the surface of each TEM 350a, 350b, 350c in contact with the thermally conductive body 330 is cold, relative to the surface in contact with the thermally conductive body 340, the vapor condenses on the wick 362 proximate the TEMs 350a, 350b, 350c. The heat of condensation is pumped by the TEMs 350a, 350b, 350c to the thermally conductive body 340.

In the thermally conductive body 340, the heat transported by the TEMs 350a, 350b, 350c causes the working fluid in a wick 370 to vaporize. The vapor diffuses through the chamber 365 and condenses on the wick 370 proximate the heat sink 120. The heat sink 120 may be cooled by, e.g., air or a liquid to remove the heat of condensation from the thermally conductive body 330. The heat sink 120 may have a larger footprint than the TEMs 350. The thermally conductive body 340 and the heat sink 120 may be configured to provide as large an area to dissipate heat as desired, as limited by available area in the system design.

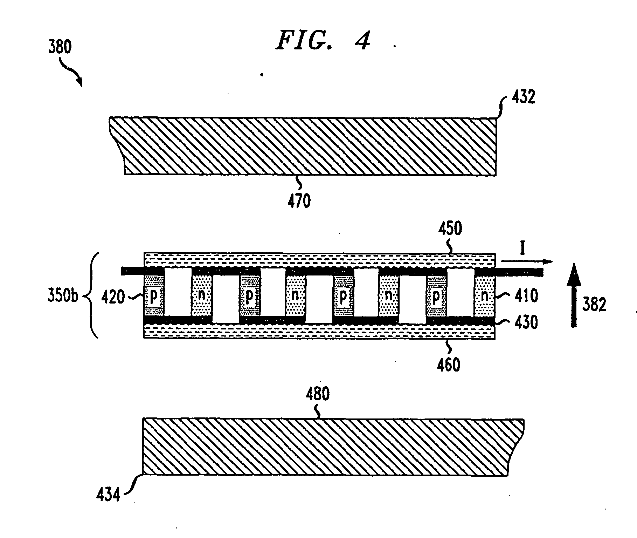

Turning to FIG. 4, the portion 380 of the apparatus 300 is illustrated in greater detail and in exploded view for clarity. The structural features of the TEM 350b are also shown for discussion purposes. Those skilled in the pertinent art are familiar with TEM construction. The following description is illustrative and not intended to limit the TEM to any particular configuration. The TEM 350b includes n-pellets 410 and p-pellets 420 connected in serial fashion by conductors 430. Insulating layers 440 electrically isolate the conductors 430 from a finger 432 of the thermally conductive body 330 and a finger 434 of the thermally conductive body 340, and may act as a substrate, providing mechanical support. Any currently existing or future-developed materials and assembly techniques of the TEM are within the scope of this disclosure.

The size of a TEM may is limited to a maximum, such as, e.g., about 5 cm on a side, due to differential thermal expansion of the warm and cold sides. In the example embodiments described herein, when a design requires a TEM with a dimension greater than the allowable maximum for the type of TEM employed, a number TEMPs with dimensions of smaller than the applicable maximum may be used. In such embodiments, each of the multiple TEMs is in thermal contact with, e.g., both the thermally conductive body 330 and the thermally conductive body 340.

The TEM 350b is configured such that a current I produces a thermal gradient 382 that, e.g., cools an upper major surface 450 of the TEM 350b and warms an opposing lower major surface 460. The major surfaces are the surfaces through which heat is transported when the TEM 350b is operating. The n-pellets 410 and p-pellets 420 have relatively low thermal conductivity, e.g., 10-20 W/m-k. Thus, the TEM 350b acts as a thermal insulator through which the heat flux may be modulated by the current I.

In an example embodiment, one or both thermally conductive bodies 330, 340 are mated to the TEM 350b to form a single integrated structure. In other words, the thermally conductive body 330, e.g., acts as the substrate for the pellets 410, 420 and the conductors 430. In such an embodiment, electrical isolation of the conductors 430 from the vapor chamber may be provided by, e.g., a thin polymer layer. Additional details on integration of a vapor chamber and a TEM are provided in U.S. Patent Application Serial No. 12/128,478 to Hodes, et al..

In the apparatus 300, e.g., the upper major surface 450 is placed in thermal contact with a lower surface 470 of the finger 432. Similarly, the lower major surface 460 is placed in thermal contact with an upper surface 480 of the finger 434. Optionally, a thermal conduction aid such as, e.g., thermal grease, may be used between the TEM 350b and the fingers 432, 434.

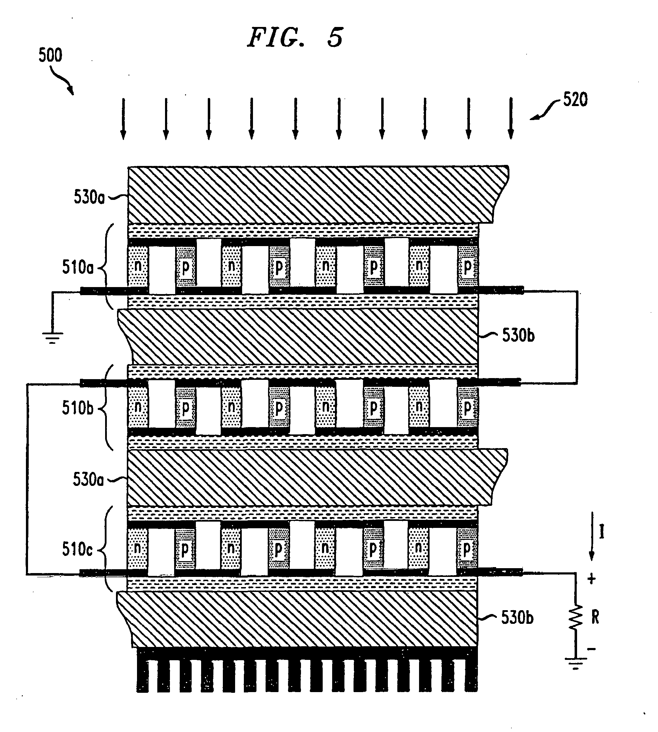

Turning to FIG. 5, an example apparatus 500 is illustrated in which TEMs 510a, 510b, 510c (collectively TEMs 510) are configured to produce power in response to heat output by a heat source 520. Portions of fingers 530a, 530b are omitted for clarity. While three TEMs are used in this example embodiment, more TEMs may be used, subject to, e.g., available vertical height and the finite thermal conductivity of the bodies of which the fingers 530a, 530b are a part. Because the heat from the heat source 520 is distributed among the three TEMs 510, each TEM 510a, 510b, 510c operates with a lower heat flux than would be the case if fewer TEMs, e.g., one TEM, were used. In a manner analogous to the increased cooling efficiency of a TEM with lower heat flux, the TEMs 510 configured to produce power also operate more efficiently with lower heat flux. Thus, a greater portion of the power available form the heat source 520 is converted to electrical power than if fewer TEMs were used. Moreover, when the heat flux is lowered, relatively more heat is converted to a useful form, e.g., electrical power, rather than being pumped through TEMs.

Because the heat flux through each TEM 510a, 510b, 510c is lower in the power-generation embodiment, the temperature difference between the two sides of the TEM is reduced relative to a higher flux case. Thus, an electrical component, e.g., being cooled by the apparatus 500 may operate at a lower temperature than if a single TEM with a higher heat flux were used to generate power. In other words, the apparatus 500, by virtue of spreading the heat flux over a larger number of pellets, allows an electrical component to operate at a lower temperature for the same total heat flux from the electrical component through the several TEMs. This aspect may allow a greater portion of the heat dissipated by the electrical component to be harnessed to produce power than would otherwise be possible without risking reducing the lifetime of the component due to high temperature operation. This aspect is in contrast to the current state of the art in thermal power recovery, in which typically a relatively small portion of waste heat may be recovered from an electrical component because of the thermally insulating characteristic of the TEM.

The TEMs 510 may be connected electrically in series, e.g., to a load R to produce I²R watts of power. As described previously, the heat source 520 may be an electrical component or a conduit for hot exhaust. The scavenged power may be used for any desired purpose. Configuring the TEMs 510 in the manner described in the various embodiments herein provides that a greater fraction of the available waste heat is converted to useful power. In other embodiments, not shown, the TEMs 510 are connected electrically in parallel. In such embodiments the recovered power is provided at higher current and lower voltage than in the illustrated series configuration.

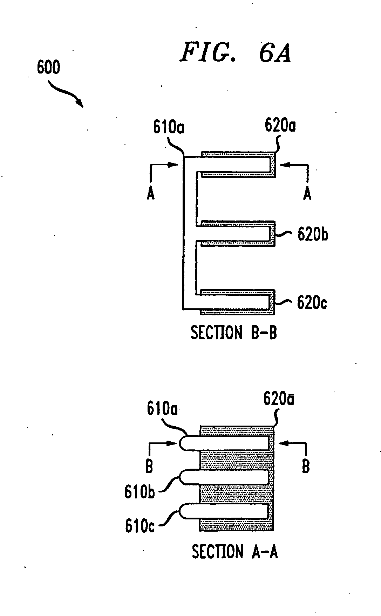

FIG. 6A illustrates an example embodiment in which a thermally conductive body 600 includes a number of heat pipes 610a, 610b, 610c (collectively heat pipes 610). The heat pipes 610 are inserted into thermally conductive blocks 620a, 620b, 620c. In the present example, three heat pipes 610 are used, but any number may be used as desired by the overall system requirements and constrained by, e.g., mechanical strength of the heat pipes 610 and the thermally conductive blocks 620.

The working fluid and vapor circulate independently in each heat pipe 610a, 610b, 610c. This aspect of the embodiment provides a means to tailor the heat flow from different areas of a TEM in thermal contact with a thermally conductive block 620. For example, the heat pipe 610b may be configured to transport heat at a greater rate than the heat pipes 610a, 610c to remove heat from an interior region of a TEM away from the edges thereof. The heat pipe 610b may be, e.g., configured with a different diameter than the heat pipes 610a, 610c.

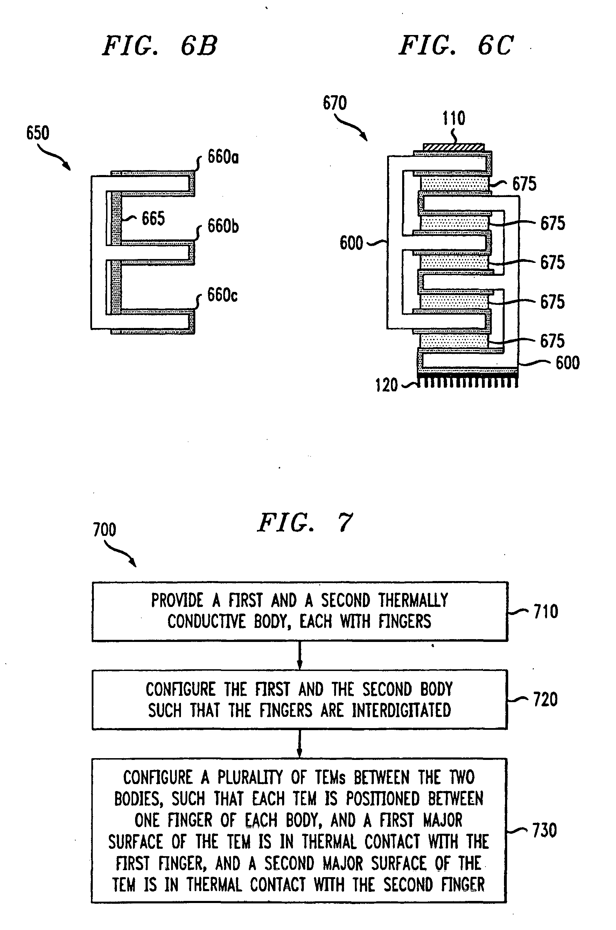

FIG. 6B illustrates an example embodiment of a thermally conductive body 650. In this embodiment, the thermally conductive blocks 660a, 660b, 660c (collectively thermally conductive blocks 660) are joined by a support member 665. The support member 665 may serve to mechanically support the thermally conductive body 650. The support member 665 may be of the same or a different material as the thermally conductive blocks 660. In an embodiment, the support member 665 and the thermally conducive blocks 660 are a monolithic structure of a material having a high thermal conductivity, e.g., 200 W/m-k or greater.

FIG. 6C illustrates an apparatus 670 that includes the heat source 110, two thermally conductive bodies 600, five TEMs 675 and a heat sink 120. The apparatus 670 is expected to operate similarly to the apparatus 100 described previously.

Finally, turning to FIG. 7, flow chart of a method 700 is illustrated. In a step 710, a first thermally conductive body and a second thermally conductive body are provided. One thermally conductive body is configured to have at least one finger, and the other is configured to have a plurality of fingers. In a step 720, the first thermally conductive body and the second conductive body are configured relative to each other such that the fingers of one thermally conductive body are interdigitated with the fingers of the other thermally conductive body. In a step 730, a plurality of TEMs is configured such that a first major surface of each TEM is in thermal contact with the first thermally conductive body, and an opposing second major surface is in thermal contact with the second thermally conductive body.

Those skilled in the art to which the invention relates will appreciate that other and further additions, deletions, substitutions and modifications may be made to the described embodiments without departing from the scope of the invention.

## Claims

1. An apparatus (100), comprising:
a first thermally conductive body (130) having at least one finger (135a, 135b, 135c);
a second thermally conductive body (140) having a plurality of fingers (145a, 145b, 145c),
**CHARACTERIZED IN THAT**
said plurality of fingers (145a, 145b, 145c) are configured such that at least a first finger (145a, 145b, 145c) and a second finger (145a, 145b, 145c) of said plurality of fingers (145a, 145b, 145c) include a portion of a same vapor chamber (365), and said second body (140) provides a path for vapor transport from said first finger (145a, 145b, 145c) to said second finger (145a, 145b, 145c), and further configured such that said at least one finger (135a, 135b, 135c) of said first thermally conductive body (130) is interdigitated with said first finger (145a, 145b, 145c) and said second finger (145a, 145b, 145c) of said second thermally conductive body (140); and
a plurality of thermoelectric modules (150a, 150b, 150c, 150d, 150e) located between said first thermally conductive body (130) and said second thermally conductive body (140), each thermoelectric module (150a, 150b, 150c, 150d, 150e) having at least one semiconducting pellet (410, 420) located entirely between a first major surface (450) and an opposing second major surface (460) thereof, one of said first major surfaces (450) being in thermal contact with said at least one finger (135a, 135b, 135c) of said first thermally conductive body (130) and one of said second major surfaces (460) being in thermal contact with said first finger (145a, 145b, 145c) or said second finger (145a, 145b, 145c) of said second thermally conductive body (140).

2. The apparatus (100) as recited in Claim 1, further comprising a heat source (110) in thermal contact with said first thermally conductive body (130) and a heat sink (120) in thermal contact with said second thermally conductive body (140).

3. The apparatus (100) as recited in Claim 2, wherein said thermoelectric modules (150a, 150b, 150c, 150d, 150e) are configured to produce electrical power in response to heat produced by said heat source (160).

4. The apparatus (100) as recited in Claim 1, wherein said thermoelectric modules (150a, 150b, 150c, 150d, 150e) are configured to transport heat between said first thermally conductive body (130) and said second thermally conducive body (140).

5. The apparatus (100) as recited in Claim 1, said same vapor chamber (365) is a second vapor chamber (365) and said first thermally conductive body (130) contains a first vapor chamber (360).

6. A method (700), comprising:
providing a first thermally conductive body (130) having at least one finger (135a, 135b, 135c);
providing a second thermally conductive body (140) having a plurality of fingers (145a, 145b, 145c),
**CHARACTERIZED IN THAT**
said plurality of fingers (145a, 145b, 145c) are configured such that at least a first finger (145a, 145b, 145c) and a second finger (145a, 145b, 145c) of said plurality of fingers (145a, 145b, 145c) include a portion of a same vapor chamber (365) and said second body (140) provides a path for vapor transport from said first finger (145a, 145b, 145c) to said second finger (145a, 195b, 145c);
configuring said first and second thermally conductive bodies (130, 140) such that said at least one finger (135a, 135b, 135c) of said first thermally conductive body (130) is interdigitated with said first finger (145a, 145b, 145c) and said second finger (145a, 145b, 145c) of said second thermally conductive body (140); and
locating a plurality of thermoelectric modules (150a, 150b, 150c, 150d, 150e) between said first thermally conductive body (130) and said second thermally conductive body (140), each thermoelectric module (150a, 150b, 150c, 150d, 150e) having at least one semiconducting pellets (410, 420) located entirely between a first major surface (450) and an opposing second major surface (460) thereof and being located such that one of said first major surfaces (450) is in thermal contact with said at least one finger (135a, 135b, 135c) of said first thermally conductive body (130) and one of said second major surfaces (460) is in thermal contact with said first finger (145a, 145b, 145c) or said second finger (145a, 145b, 145c) of said second thermally conductive body (140).

7. The method (700) as recited in Claim 6, wherein said same vapor chamber (365) is a second vapor chamber (365) and said first thermally conductive body (130) contains a first vapor chamber (360).

8. The method (700) as recited in Claim 6, further comprising placing a heat source (110) in thermal contact with said first thermally conductive body (130) and a heat sink (120) in thermal contact with said second thermally conductive body (140).

9. The apparatus (100) as recited in Claim 1,
wherein the apparatus (100) is part of a system, said system further including:
a controller configured to control a rate of heat transport between said first thermally conductive body (130) and said second thermally conductive body (140) through said plurality of thermoelectric modules (150a, 150b, 150c, 150d, 150e).

## Patentansprüche

1. Vorrichtung (100), umfassend:
Einen ersten thermisch leitfähigen Körper (130) mit mindestens einem Finger (135a, 135b, 135c);
einen zweiten thermisch leitfähigen Körper (140) mit einer Vielzahl von Fingern (145a, 145b, 145c);
**DADURCH GEKENNZEICHNET, DASS**
die besagte Vielzahl von Fingern (145a, 145b, 145c) derart konfiguriert sind, dass zumindest ein erster Finger (145a, 145b, 145c) und ein zweiter Finger (145a, 145b, 145c) der besagten Vielzahl von Fingern (145a, 145b, 145c) einen Abschnitt einer selben Dampfkammer (365) umfassen, und dass der besagte zweite Körper (140) einen Pfad für den Dampftransport von dem besagten ersten Finger (145a, 145b, 145c) zu dem besagten zweiten Finger (145a, 145b, 145c) bereitstellt, und weiterhin derart konfiguriert sind, dass der besagte mindestens eine Finger (135a, 135b, 135c) des besagten ersten thermisch leitfähigen Körpers (130) und der besagte erste Finger (145a, 145b, 145c) sowie der besagte zweite Finger (145a, 145b, 145c) des besagten zweiten thermisch leitfähigen Körpers (140) ineinandergreifen; und
eine Vielzahl von thermoelektrischen Modulen (150a, 150b, 150c, 150d, 150e), welche wischen dem besagten ersten thermisch leitfähigen Körper (130) und dem besagten zweiten thermisch leitfähigen Körper (140) angeordnet sind, wobei jedes thermoelektrische Modul (150a, 150b, 150c, 150d, 150e) mindestens ein vollständig zwischen einer ersten Hauptfläche (450) und einer dieser gegenüberliegenden zweiten Hauptfläche (460) angeordnetes halbleitendes Plättchen (410, 420) aufweist, wobei eine der besagten ersten Hauptflächen (450) mit dem besagten mindestens einen Finger (135a, 135b, 135c) des besagten ersten thermisch leitfähigen Körpers (130) in thermischem Kontakt steht und eine der besagten zweiten Hauptflächen (460) mit dem besagten mindestens ersten Finger (145a, 145b, 145c) oder dem besagten zweiten Finger (145a, 145b, 145c) des besagten zweiten thermisch leitfähigen Körpers (140) in thermischem Kontakt steht.

2. Vorrichtung (100) nach Anspruch 1, weiterhin umfassend eine Wärmequelle (110), welche mit dem besagten ersten thermisch leitfähigen Körper (130) in thermischem Kontakt steht, und einen Kühlkörper (120), welcher mit dem besagten zweiten thermisch leitfähigen Körper (140) in thermischem Kontakt steht.

3. Vorrichtung (100) nach Anspruch 2, wobei die besagen thermoelektrischen Module (150a, 150b, 150c, 150d, 150e) dafür konfiguriert sind, in Reaktion auf die von der Wärmequelle (160) erzeugten Wärme elektrische Energie zu erzeugen.

4. Vorrichtung (100) nach Anspruch 1, wobei die besagten thermoelektrischen Module (150a, 150b, 150c, 150d, 150e) dafür konfiguriert sind, Wärme zwischen dem besagten ersten thermisch leitfähigen Körper (130) und dem besagten zweiten thermisch leitfähigen Körper (140) zu transportieren.

5. Vorrichtung (100) nach Anspruch 1, wobei die besagte selbe Dampfkammer (365) eine zweite Dampfkammer (365) ist und der besagte erste thermisch leitfähige Körper (130) eine erste Dampfkammer (360) enthalt.

6. Verfahren (700), umfassend:
Bereitstellen eines ersten thermisch leitfähigen Körpers (130) mit mindestens einem Finger (135a, 135b, 135c);
Bereitstehen eines zweiten thermisch leitfähigen Körpers (140) mit einer Vielzahl von Fingern (145a, 145b, 145c);
**DADURCH GEKENNZEICHNET, DASS**
die besagte Vielzahl von Fingern (145a, 145b, 145c) derart konfiguriert sind, dass zumindest ein erster Finger (145a, 145b, 145c) und ein zweiter Finger (145a, 145b, 145c) der besagten Vielzahl von Fingern (145a, 145b, 145c) einen Abschnitt einer selben Dampfkammer (365) umfassen, und dass der besagte zweite Körper (140) einen Pfad für den Dampftransport von dem besagten ersten Finger (145a, 145b, 145c) zu dem besagten zweiten Finger (145a, 145b, 145c) bereitstellt;
Konfigurierten des besagten ersten und des besagten zweiten thermisch leitfähigen Körpers (130; 140), derart, dass der besagte mindestens eine Finger (135a, 135b, 135c) des besagten ersten thermisch leitfähigen Körpers (130) und der besagte erste Finger (145a, 145b, 145c) sowie der besagte zweite Finger (145a, 145b, 145c) des besagten zweiten thermisch leitfähigen Körpers (140) ineinandergreifen; und
Anordnen einer Vielzahl von thermoelektrischen Modulen (150a, 150b, 150c, 150d, 150e) zwischen dem besagten ersten thermisch leitfähigen Körper (130) und dem besagten zweiten thermisch leitfähigen Körper (140), wobei jedes thermoelektrische Modul (150a, 150b, 150c, 150d, 150e) mindestens ein vollständig zwischen einer ersten Hauptfläche (450) und einer dieser gegenüberliegenden zweiten Hauptfläche (460) angeordnetes halbleitendes Plättchen (410, 420) aufweist und derart angeordnet ist, dass eine der besagten ersten Hauptflächen (450) mit dem besagten mindestens einen Finger (135a, 135b, 135c) des besagten ersten thermisch leitfähigen Körpers (130) in thermischem Kontakt steht und eine der besagten zweiten Hauptflächen (460) mit dem besagten mindestens ersten Finger (145a, 145b, 145c) oder dem besagten zweiten Finger (145a, 145b, 145c) des besagten zweiten thermisch leitfähigen Körpers (140) in thermischem Kontakt steht.

7. Verfahren (700) nach Anspruch 6, wobei die besagte selbe Dampfkammer (365) eine zweige Dampfkammer (365) ist und der besagte erste thermisch leitfähige Körper (130) eine erste Dampfkammer (360) enthält.

8. Verfahren (700) nach Anspruch 6, weiterhin umfassend das Versetzen einer Wärmequelle (110) in thermischen Kontakt mit dem besagten ersten thermisch leitfähigen Körper (130) und das Versetzen eines Kühlkörpers (120) in thermischen Kontakt mit dem besagten zweiten thermisch leitfähigen Körper (140).

9. Vorrichtung (100) nach Anspruch 1,
wobei die Vorrichtung (100) Bestandteil eines Systems ist, wobei das besagte System weiterhin umfasst:
einen Controller, dafür konfiguriert, eine Geschwindigkeit des Wärmetransports zwischen dem besagten ersten thermisch leitfähigen Körper (130) und dem besagten zweiten thermisch leitfähigen Körper (140) über die besagte Vielzahl von thermoelektrischen Modulen (150a, 150b, 150c, 150d, 150e) zu steuern.

## Revendications

1. Appareil (100) comprenant :
un premier corps (130) thermiquement conducteur muni d'au moins une languette (135a, 135b, 135e);
un deuxième corps (140) thermiquement conducteur muni d'une pluralité de languettes (145a, 145b, 145c),
**CARACTÉRISÉ EN CE QUE**
ladite pluralité de languettes (145a, 145b, 145c) sont configurées de telle sorte qu'au moins une première languette (145a, 145b, 145c) et une deuxième languette (145a, 145b, 145c) de ladite pluralité de languettes (145a, 145b, 145c) incluent une portion d'une même chambre à vapeur (365), et ledit deuxième corps (140) produit un trajet pour le transport de la vapeur de ladite première languette (145a, 145b, 145c) à ladite deuxième languette (145a, 145b, 145c), et en outre configurées de telle sorte que ladite au moins une languette (135a, 135b, 135c) dudit premier corps (130) thermiquement conducteur est interdigité avec ladite première languette (145a, 145b, 145c) et ladite deuxième languette (145a, 145b, 145c) dudit deuxième corps (140) thermiquement conducteur ; et
une pluralité de modules thermoélectriques (150a, 150b, 150c, 150d, 150e) situés entre ledit premier corps (130) thermiquement conducteur et ledit deuxième corps (140) thermiquement conducteur, chaque module thermoélectrique (150a, 150b, 150c, 150d, 150e) possédant au moins un granulé semiconducteur (410, 420) entièrement situé entre une première surface principale (450) et une deuxième surface principale (460) opposée de celui-ci, l'une desdites premières surfaces principales (450) se trouvant en contact thermique avec ladite au moins une languette (135a, 135b, 135c) dudit premier corps (130) thermiquement conducteur et l'une desdites deuxièmes surfaces principales (460) se trouvant en contact thermique avec ladite première languette (145a, 145b, 145c) ou ladite deuxième languette (145a, 145b, 145c) dudit deuxième corps (140) thermiquement conducteur.

2. Appareil (100) selon la revendication 1, comprenant en outre une source de chaleur (110) en contact thermique avec ledit premier corps (130) thermiquement conducteur et un dissipateur de chaleur (120) en contact thermique avec ledit deuxième corps (140) thermiquement conducteur.

3. Appareil (100) selon la revendication 2, avec lequel lesdits modules thermoélectriques (150a, 150b, 150c, 150d, 150e) sont configurés pour produire de l'énergie électrique en réponse à la chaleur produits par ladite source de chaleur (160).

4. Appareil (100) selon la revendication 1, avec lequel lesdits modules thermoélectriques (150a, 150b, 150c, 150d, 150e) sont configurés pour transporter la chaleur entre ledit premier corps (130) thermiquement conducteur et ledit deuxième corps (140) thermiquement conducteur.

5. Appareil (100) selon la revendication 1, avec lequel ladite chambre à vapeur (365) est une deuxième chambre à vapeur (365) et ledit premier corps (130) thermiquement conducteur continent une première chambre à vapeur (360).

6. Procédé (700) comprenant :
production d'un premier corps (130) thermiquement conducteur muni d'au moins une languette (135a, 135b, 135c) ;
production d'un deuxième corps (140) thermiquement conducteur muni d'une pluralité de languettes (145a, 145b, 145c),
**CARACTÉRISÉ EN CE QUE**
ladite pluralité de languettes (145a, 145b, 145c) sont configurées de telle sorte qu'au moins une première languette (145a, 145b, 145c) et une deuxième languette (145a, 145b, 145c) de ladite pluralité de languettes (145a, 145b, 145c) incluent une portion d'une même chambre à vapeur (365), et ledit deuxième corps (140) produit un trajet pour le transport de la vapeur de ladite première languette (145a, 145b, 145c) à ladite deuxième languette (145a, 145b, 145c) ;
configuration desdits premier et deuxième corps (130, 140) thermiquement conducteurs de telle sorte que ladite au moins une languette (135a, 135b, 135c) dudit premier corps (130) thermiquement conducteur est interdigité avec ladite première languette (145a, 145b, 145c) et ladite deuxième languette (145a, 145b, 145c) dudit deuxième corps (140) thermiquement conducteur ; et
implantation d'une pluralité de modules thermoélectriques (150a, 150b, 150c, 150d, 150e) entre ledit premier corps (130) thermiquement conducteur et ledit deuxième corps (140) thermiquement conducteur, chaque module thermoélectrique (150a, 150b, 150c, 150d, 150e) possédant au moins un granulé semiconducteur (410, 420) entièrement situé entre une première surface principale (450) et une deuxième surface principale (460) opposée de celui-ci et étant implante de telle sorte que l'une desdites premières surfaces principales (450) se trouve en contact thermique avec ladite au moins une languette (135a, 135b, 135c) dudit premier corps (130) thermiquement conducteur et l'une desdites deuxièmes surfaces principales (460) se trouve en contact thermique avec ladite première languette (145a, 145b, 145c) ou ladite deuxième languette (145a, 145b, 145c) dudit deuxième corps (140) thermiquement conducteur.

7. Procédé (700) selon la revendication 6, selon lequel ladite chambre à vapeur (365) est une deuxième chambre à vapeur (365) et ledit premier corps (130) thermiquement conducteur contient une première chambre à vapeur (360).

8. Procédé (700) selon la revendication 6, comprenant en outre la misé en contact thermique d'une source de chaleur (110) avec ledit premier corps (130) thermiquement conducteur et d'un dissipateur de chaleur (120) en contact thermique avec ledit deuxième corps (140) thermiquement conducteur.

9. Appareil (100) selon la revendication 1,
avec lequel l'appareil (100) fait partie d'un système, ledit système comprenant en outre :
un contrôleur configuré pour commander un taux de transfert de chaleur entre ledit premier corps (130) thermiquement conducteur et ledit deuxième corps (140) thermiquement conducteur à travers ladite pluralité de modules thermoélectriques (150a, 150b, 150c, 150d, 150e).
